# EUROPEAN PATENT SPECIFICATION

(11) **EP 2 673 785 B1**
(45) Date of publication and mention of the grant of the patent: **02.10.2019**
(21) Application number: 12704751.2
(22) Date of filing: 09.02.2012
(51) Int. Cl.: H01B 1/02, H01H 1/02, H01H 1/023

(54) **MATERIAL FOR PROVIDING AN ELECTRICALLY CONDUCTING CONTACT LAYER, A CONTACT ELEMENT WITH SUCH LAYER, METHOD FOR PROVIDING THE CONTACT ELEMENT, AND USES OF THE MATERIAL**
MATERIAL ZUR BEREITSTELLUNG EINER ELEKTRISCH LEITENDEN KONTAKTSCHICHT, KONTAKTELEMENT MIT EINER SOLCHEN SCHICHT, VERFAHREN ZUR BEREITSTELLUNG DES KONTAKTELEMENTS UND VERWENDUNG DES MATERIALS
MATÉRIAU DESTINÉ À PRODUIRE UNE COUCHE DE CONTACT ÉLECTRIQUEMENT CONDUCTRICE, ÉLÉMENT DE CONTACT POSSÉDANT UN TELLE COUCHE, PROCÉDÉ DESTINÉ À PRODUIRE CET ÉLÉMENT DE CONTACT, ET UTILISATIONS DE CE MATÉRIAU

(30) Priority: 09.02.2011 SE 1150101; 09.02.2011 US 201161440978 P
(43) Date of publication of application: 18.12.2013
(73) Proprietor: Impact Coatings AB, 582 16 Linköping (SE)
(72) Inventor: LJUNGCRANTZ, Henrik, S-587 21 Linköping (SE); ULRICH, Christian, S-582 38 Linköping (SE); FLINK, Axel, S-582 14 Linköping (SE); JOELSSON, Torbjörn, S-584 37 Linköping (SE)
(74) Representative: Valea AB
(86) International application number: PCT/EP2012/052222
(87) International publication number: WO 2012/107524

(56) References cited:
- EP-A1- 1 475 814
- EP-A1- 1 489 193
- WO-A1-2008/123259
- DE-B1- 2 637 490
- DE-C1- 3 932 535
- US-A- 2 157 933
- US-A1- 2002 096 662
- US-A1- 2005 089 439

## Description

### Technical field

The present disclosure relates generally to electrically conducting contact layers and to materials for providing such layers.

### Background

Electrically conducting contact elements, that is, elements adapted for electrically connecting a device, such as plug-in connectors and sliding- or stationary contacts, often comprise a conducting metallic body, and, to improve certain properties, e.g. electrical and/or protective properties, an electrically conducting contact layer covering at least a contact area of the contact element. Protection can be in regard to wear, corrosion or other detrimental chemical reactions that may take part with the environment where the contact element has its use.

Gold is one material that often is suitable as a contact layer, but is expensive. A potential gold replacement is silver. However, silver is not as inert as often would be desirable or needed, and some properties may therefore need to be further improved, such as resistance to corrosion, in particular in environments containing Cl⁻ and/or H₂S, that otherwise tend to react with silver and create a surface layer with deteriorated electrical properties.

In WO 2010/005382 A1 a conductive layer of a silver-indium alloy consisting of 1-10 % by weight of In and 90-99 % by weight of Ag, in particular 5 % by weight of In and 95 % by weight of Ag, is provided on the surface of a strip substrate. The electrical properties of the alloy were good and it did not easily react with sulfur in the ambient air.

EP1489193 discloses a sputter target of silver based alloy consisting of 0.01-5.0 % by weight of In and Sn, in particular 0.5 % by weight of In and 0.5 % by weight of Sn, and the rest consisting of silver.

US6565983 discloses an electrical contact element with a contact surface coated with a 0.001 µm to 1 mm thick friction reducing layer comprising a metal salt being a metal halogenide or metal sulfide.

US7670689 discloses a sulfidation-resistant silver base coating comprising a stack of one main layer made from silver-base material and one oxidized thin film between 10 nm and 1 µm.

T.R. Long, Platinum Metals Rev., 1976, 20, 46-47 discloses that a silver based alloy consisting of more than 20 wt.% Pd has improved resistance to corrosion. US 2002/0096662 discloses an electrically conductive metal tape comprising a base material and an intermetallic phase between the base material and the coating.The conductive contact material comprises a copper alloy and a tin silver alloy comprising 1 to 3.8 weight% silver further comprising 10 weight% indium.

EP1475814 discloses an electrical contact made of silver alloy, comprising 1 to 9 weight% In and Sn each.

### Summary of the invention

In view of the above, an object of this disclosure is to present a solution overcoming or at least alleviating problems in the prior art, or to at least present an alternative solution. A more specific object is to present a solution enabling provision of an electrically conducting contact layer comprising an electrically conducting metallic base material, where the contact element has improved corrosion resistance compared to a contact element made of the electrically conducting metallic base material as such.

It has been found that corrosion resistance of an electrically conducting base material, in particular of silver, can be improved in regard of sulfidation (tarnishing) by addition of In and Sn (up to 10 at.%, that is, atomic percent), but that resistance to salt spray corrosion is not as good as would be desirable. Silver based materials with high Pd content (>20 wt.%) have previously been found to improve resistance to corrosion. However, the high price of Pd makes such material less commercially interesting. A material with less Pd content would therefore be preferable, but corrosion resistance to H₂S is then not sufficient. Investigations of silver based materials including both In+Sn and Pd revealed that the corrosion resistance effect from In+Sn and Pd could counteract each other, for example that Pd could adversely affect sulfidation resistance compared to when In+Sn was used without Pd. One challenge was thus to find a material with In+Sn and Pd, which enabled sufficiently improved corrosion resistance both to sulfidation and salt spray corrosion. Additionally, it was found that instead of basing the material on metal, e.g. pure silver, a metal salt, such as silver salt, could be used, either as the base material as such, or as an additive to the material, thereby enabling increase of corrosion resistance as well as lowering the friction coefficient of the material, while maintaining a low contact resistance. Although investigations has focused on silver as metal of the base material, the In+Sn and Pd additives could also be used with other base material metals, in general with silver, copper, tin, nickel or cobalt, a first metal salt of one thereof, or to alloys thereof.

The invention is defined by the appended independent claims. Embodiments are set forth in the dependent claims and in the following description and drawings.

Hence, the above-mentioned and other objects and advantages, which will be evident from the following description, are:
According to a first aspect achieved by a material for providing an electrically conducting contact layer, the material comprising a base material being any one of Ag, Ni, Co, a first metal salt of any one thereof, or an alloy of any one or more thereof, wherein the material further comprises In within a range of 0.01 at.% to 10 at.% and Sn within a range of 0.01 at.% to 10 at.%, unless already the base material comprises Sn at a higher amount, and at least one element selected from the group including Au, Ag, Pd, Pt, Rh, Ir, Ru, Os, Re, or any combination thereof, within a range of 0.01 at.% to 10 at.%, unless the at least one element already is present in the base material.

From such material, a contact layer can be provided that, compared to a coating of only the base material, has improved corrosion resistance and low contact resistance. By base material is here meant a material constituting at least 50 at.% of the material and being the target for the improved corrosion resistance.

The base material may be Ag. In one embodiment the material may comprise less than or about 5 at.% In, less than or about 10 at.% Sn, and less than or about 5 at.% of the at least one element or combinations of elements. The material may comprise the base material within a range of 70 at.% to 99.7 at.%, such that the sum of all constituents in the material is 100 at.%. This means that for a contact layer composition comprising for example 10 at.% In, 10 at. % Sn and 10 at.% Pt, the rest, 70 at.%, would consist of the base material chosen.

According to an alternative a material is provided for providing an electrically conducting contact layer, the material comprising a base material being any one of Ag, Ni, a first metal salt of one thereof, or an alloy of one or more thereof, wherein the material further comprises In within a range of 0.01 at.% to 10 at.%, Pd within a range of 0.01 at.% to 10 at.%, and, unless already the base material comprises Sn at a higher amount, Sn within a range of 0.01 at.% to 10.

The base material may be Ag. In one embodiment the material may comprise less than or about 1.5 at.% In, less than or about 1.5 at.% Sn, and less than or about 3 at.% Pd.

The material may further comprise at least about 0.01 at.% of a second metal salt, preferably a metal halogenide or metal sulfide. By addition of the second metal salt, resistance to corrosion can be further improved. The second metal salt may comprise one or more of the following metals: Ag, Sn and Cu. The second metal salt may be a metal halogenide comprising one or more of the following halogenides: iodide, chloride and bromide.

In one embodiment the first metal salt of one of Ag, Ni, is the base material and the first metal salt is one or more of iodide and bromide. The first metal salt may be Agl or AgBr.

In one embodiment the material may further comprise at least one element selected from the group including Au, Ag, Pt, Rh, Ir, Ru, Os, Re, or any combination thereof, within the range of 0.01 at. % to 10 at. %, unless the at least one element already is present in the base material.

Such a material may comprise less than or about 10 at.% of the at least one element or combinations of elements, such that the sum of Pd and the at least one element or combinations of elements is less than or about 10 at.%.

In one embodiment the material may comprise the base material within a range of 70 at.% to 99.7 at.%, such that the sum of all constituents in the material is 100 at.%.

According to an alternative a material providing an electrically conducting contact layer is provided, the material comprising a base material being any one of Ag, Ni, Co, a first metal salt of any one thereof, or an alloy of any one or more thereof, wherein the material further comprises In within a range of 0.01 at.% to 10 at.%, Pd within a range of 0.01 at.% to 10 at.%, and, unless already the base material comprises Sn at a higher amount, Sn within a range of 0.01 at.% to 10 at.%.

The base material may be Ag.

In one embodiment the material may further comprise at least one element selected from the group including Au, Ag, Pt, Rh, Ir, Ru, Os, Re, or any combination thereof, within the range of 0.01 at. % to 10 at. %, unless the at least one element already is present in the base material.

Such a material may comprise less than or about 10 at.% of the at least one element or combinations of elements, such that the sum of Pd and the at least one element or combinations of elements is less than or about 10 at.%.

In one embodiment the material may comprise the base material within a range of 70 at.% to 99.7 at.%, such that the sum of all constituents in the material is 100 at.%.

According to an alternative a a material is provided for providing an electrically conducting contact layer, the material comprising a base material being any one of Ag, Ni, Co, a first metal salt of any one thereof, or an alloy of any one or more thereof, wherein the material further comprises In within a range of 0.01 at.% to 10 at.%, and at least one element selected from the group including Au, Ag, Pd, Pt, Rh, Ir, Ru, Os, Re, or any combination thereof, within a range of 0.01 at.% to 10 at.%, unless the at least one element already is present in the base material.

The base material may be Ag. In one embodiment the material may comprise less than or about 5 at.% In and less than or about 5 at.% of the at least one element or combinations of elements.

In one embodiment the material may comprise the base material within a range of 80 at.% to 99.8 at.%, such that the sum of all constituents in the material is 100 at.%.

According to an alternative a material is provdided for providing an electrically conducting contact layer, the material comprising a base material being any one of Ag, Ni, Co, a first metal salt of any one thereof, or an alloy of any one or more thereof, wherein the material further comprises Sn within a range of 0.01 at.% to 10 at.%, unless already the base material comprises Sn at a higher amount, and at least one element selected from the group including Au, Ag, Pd, Pt, Rh, Ir, Ru, Os, or any combination thereof, within a range of 0.01 at.% to 10 at.%, unless the at least one element already is present in the base material.

The base material may be Ag. The material may comprise less than or about 10 at.% Sn and less than or about 5 at.% of the at least one element or combinations of elements.

In one embodiment the material comprises the base material within a range of 80 at.% to 99.8 at.%, such that the sum of all constituents in the material is 100 at.%.

According to a second aspect the above-mentioned and other objects and advantages are achieved by an electrically conducting contact element comprising a substrate and coated thereon a contact layer comprising the material. With "material" is here and henceforth meant any of the above described materials.

The electrically conducting contact element may further comprise an outer protective layer deposited on the contact layer, wherein said outer protective layer substantially consisting of Si, O, and C.

By "substantially consisting" is meant that the layer consists of (only) the constituents to a degree achievable under practical circumstances as will be recognized by the skilled person.

The electrically conducting contact element may further comprise an outer protective layer deposited on the contact layer, wherein said outer protective layer substantially consists of indium oxide and tin oxide.

Such outer protective layers protect the contact layer from e.g. discoloration during storage of the contact element without any significant reduction of contact resistance.

According to a third aspect the above-mentioned and other objects and advantages are achieved by a method for providing an electrically conducting contact element, comprising the steps of providing a substrate and providing the substrate with a contact layer, wherein the contact layer comprises the material.

The contact layer may be coated on the substrate by means of evaporation, preferably by physical vapor deposition, and preferably from a target material comprising the material. The physical vapor deposition techniques used may be for example dc magnetron sputtering and High Power Impulse Magnetron Sputtering (HIPIMS). Other possible coating methods are plating, chemical plating, plasma spraying, rolling, etc.

The method further comprises the step of coating the surface of the contact layer with an outer protective layer resulting from PVD or CVD of either a polymeric coating substantially consisting of Si, O, and C, or a metal oxide substantially consisting of indium oxide and tin oxide.

According to a fourth aspect the above-mentioned and other objects and advantages are achieved by use of the material as a contact layer of an electrically conducting contact element.

According to a fifth aspect the above-mentioned and other objects and advantages are achieved by a use of the material as a target material for deposition by evaporation, preferably by physical vapor deposition.

### Brief description of the drawings

The above, as well as other aspects, objects and advantages of the present invention, will be better understood through the following illustrative and non-limited detailed description, with reference to the appended schematic drawings.
Figs. 1a-b show schematic partial cross section views of embodiments of an electrically conducting contact element
Fig. 2 is a block diagram schematically showing steps in method for providing an electrically conducting contact element.
Fig. 3 shows experimental results from evaluation of an embodiment of an electrically conducting contact element before and after subjecting the element to salt spray corrosion testing and before and after exposing the element to a tarnishing environment.

In the drawings the same reference numerals are used for same, similar or corresponding features, even when the reference numerals refer to features in different embodiments.

### Detailed description

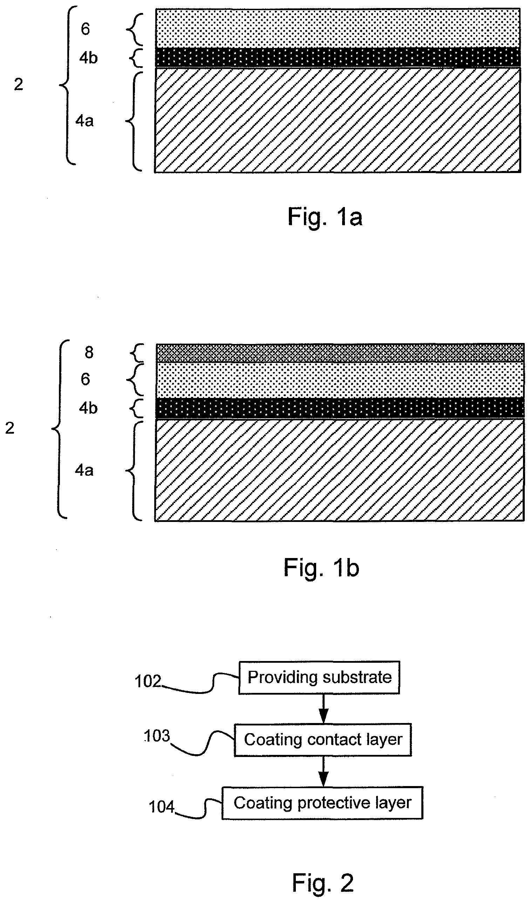

Fig. 1a shows a schematic partial cross section view of an electrically conducting contact element 2 comprising a substrate 4a, 4b and coated thereon a contact layer 6 comprising a material that will be discussed in detail below. The substrate 4a may be a copper alloy having a nickel alloy 4b plated thereon, or a stainless steel having a nickel alloy 4b coated thereon by PVD. Also other types of substrates are possible, of other materials, and/or comprising only one layer, or a stack of more than two layers. In general any conventional electrically conducting contact element substrate may be used. It is well recognized that electrical contact elements in general are used in all kinds of different applications where it is desirable to in a repeatable manner be able to create and/or break an electrical connection. Applications where the present solution may be used include i.e. connectors, switches and breakers in general, power connectors, smart card connectors, battery contact applications, charge contacts of mobile phones, contacts in consumer electronics, electrical contact elements in industry applications, car applications, defense and airspace applications, and electrical contact elements for signal applications, and including low voltage, mid-voltage and high-voltage applications. The electrically conducting contact element 2 may be used to replace any conventional electrical contact element. The material is comprising a base material that is any one of Ag, Sn, Ni, Co, a first metal salt of one thereof, or an alloy of one or more thereof, the material further comprising from 0.01 up to 10 at.% of In, from 0.01 up to 10 at.% of Sn (unless Sn is part of the base material at higher amount), and from 0.01 up to 10 at.% of Pd. Hence, the amount of each one of In, Sn and Pd is at least above 0, here at least 0.01 at.%, although in practice an effective amount would typically be at least 0.1 at.%. The base material typically constitutes substantially the rest of the material, or at least to the extent possible in practical circumstances. However, it may be possible that some amount of additional additive not being part of any of the base material, In, Sn and Pd, is present in the material as well, but should then not have any substantial detrimental effect on the effects provided by the base material in combination with the In, Sn and Pd, that is, not having any substantial detrimental effect on contact resistance and corrosion resistance compared to a situation where the material would substantially consists of the base material, In, Sn and Pd. In any case the base material should constitute at least 50 at.% of the material. More detailed embodiments of the material will follow below.

Typically the contact layer 6 is formed from the material, and may thus substantially consist of the material, but it may in some embodiments be parts, for example sub areas or sub layers of the contact layer 6, that consists of or comprises the material. The contact layer 6 may also contain additional specimen, not being part of the material as such, which for example may be partly present in the contact layer to provide some additional property or function. One more detailed example of such contact layer 6 will be given below.

The thickness of the contact layer 6 is typically above 10 µm but also smaller thicknesses are possible. However, preferably the thickness is less than 1 µm, or about 0.3 µm.

In some embodiments, the material may comprise less than or about 5 at.% In and/or 5 at.% Sn and/or 5 at.% Pd, or even less than or about 1.5 at.% In, and/or less than or about 1.5 at.% Sn, and/or less than about 3 at.% Pd. Embodiments are e.g. possible where the amount of Sn, In and Pd compared to the total material is within ranges marked A-M in Table 1 below.

**Table 1 - Examples of possible ranges**

| | Sn | In | Pd |
|---|---|---|---|
| A | ≤ 10 at.% | ≤ 10 at.% | ≤ 10 at.% |
| B | ≤ 10 at.% | ≤ 5 at.% | ≤ 10 at.% |
| c | ≤ 5 at.% | ≤ 10 at.% | ≤ 10 at.% |
| D | ≤ 5 at.% | ≤ 5 at.% | ≤ 5 at.% |
| E | ≤ 5 at.% | ≤ 5 at.% | ≤ 3 at.% |
| F | ≤ 5 at.% | ≤ 5 at.% | ≤ 10 at.% |
| G | ≤ 5 at.% | ≤ 5 at.% | ≤ 3 at.% |
| H | ≤ 5 at.% | ≤ 1.5 at.% | ≤ 10 at.% |
| I | ≤ 5 at.% | ≤ 1.5 at.% | ≤ 3 at.% |
| J | ≤ 1.5 at.% | ≤ 5 at.% | ≤ 10 at.% |
| K | ≤ 1.5 at.% | ≤ 5 at.% | ≤ 3 at.% |
| L | ≤ 1.5 at.% | ≤ 1.5 at.% | ≤ 10 at.% |
| M | ≤ 1.5 at.% | ≤ 1.5 at.% | ≤ 3 at.% |

The amounts according to A-M in table 1 is each one possible to use with any base material that is any one of Ag, , Sn, Ni, Co, a first metal salt of one thereof, but may be of particular interest when the base material is Ag.

It may be advantageous to keep a relation between In+Sn and Pd so that the at.% of Pd is less than at least about the double amount of In+Sn in at.%, or even less than about 1.5 times the amount of In+Sn in at.%.

In one more specific embodiment the substrate 4a is a Grade 304 stainless steel which has been PVD coated with a Ni-alloy, containing at least 72 at.% Ni, forming substrate layer 4b, upon which a contact layer 6 has been coated using PVD. The contact layer is formed from an Ag-alloy comprising 95.5 at.% Ag, 1 at.% In, 1 at.% Sn, and 2.5 at.% Pd.

Note that the substrate need not be electrically conductive and thus in some embodiments may be non-conductive.

In embodiments where the base material comprises a first metal salt of any one of Ag, Ni, the first metal salt is preferably one or more of iodide and bromide, such as Agl or AgBr.

In one embodiment the base material is Ag and Agl (proportion about 1:1) at 95.5 at. % and the material may further comprise about 1 at. % In, about 1 at. % Sn and about 2.5 at. % Pd.

When the base material comprises other material than Ag, that is, or Sn and/or Ni and/or Co, the amount of In, Sn and Pd may be selected in an upper part of the respective range A-M, that is at comparatively higher amounts, in order to better compensate for that these materials are less inert than Ag.

In some embodiments the material may further comprise at least about 0.01 at.%, or in practice typically at least about 0.1 at.%, of a second metal salt, preferably a metal halogenide or metal sulfide. Preferably the metal is one or more of silver, tin and copper, and preferably the halogenide is any one of iodide, chloride and bromide.

In one embodiment the base material is Ag, the material comprises about 1 at. % In, about 1 at. % Sn and about 2.5 at. % Pd, and further comprises 45% Agl (silver iodide), the rest substantially consisting of the base material Ag .

Electrically conducting contact elements 2 provided with contact layers 6 of different compositions were evaluated in environmental corrosion tests involving salt mist exposure (the test used corresponds well to the IEC 60068-2-11 Test Ka) and hydrogen sulfide exposure (the test used corresponds well to the IEC 60068-2-60 Test Ke). The electrically conducting contact elements 2 used in the environmental corrosion tests corresponds to the one shown in Fig. 1a, wherein the substrate 4a was a Grade 304 stainless steel coated with 0.3 µm Ni-alloy, containing at least 72 at.% Ni, forming substrate 4b, upon which a 0.3 µm contact layer 6 was coated.

The salt mist exposure test involved subjecting the electrically conducting contact element 2, placed in a closed container at room temperature, to a salt mist spray (NaCl 5% (w/w) in water) 5-10 times per day during 48 hours. Thereafter, the electrically conducting contact element 2 was rinsed in de-ionized water. In the hydrogen sulfide exposure test the electrically conducting contact element 2 was fixated in a beaker 10-100 mm above the surface of a 50 ml Na₂S (22.8 g/l) solution for 24 hours. The beaker was located in a closed container at room temperature.

After salt mist exposure the electrical properties of the electrically conducting contact element 2 and the corrosion resistance of the contact layer 6 of said element 2 were examined.

After exposure to hydrogen sulfide the tarnish resistance of the contact layer 6 was examined, i.e. its resistance against sulfidation. Tarnishing results in increased contact resistance of the electrically conducting contact element 2. Some contact layer 6 compositions exhibited a faint yellowish discoloration after exposure to hydrogen sulfide, which did not, however, affect the electrical properties of the electrically conducting contact element 2 negatively.

An electrically conducting contact element 2 provided with a contact layer 6 of pure Ag (100 at.%) was subject to corrosion after exposure to both salt spray and hydrogen sulfide. By addition of Pd to the contact layer 6, Ag-Pd (90-10 at.%), a considerably better corrosion resistance against salt mist and a slightly improved resistance against sulfidation was achieved than for a pure Ag contact layer 6. An even higher level of Pd in the Ag composition would, as is generally known, result in improved resistance also to sulfidation.

The corrosion resistance of an electrically conducting contact element 2 provided with a contact layer 6 comprising Ag as base material was increased with regard to tarnishing by addition of In and Sn to the base material, up to 10 at.% for Sn and below 5 at.% for In. However, resistance to salt mist corrosion was not improved for such contact layer 6 compositions.

An electrically conducting contact element 2 provided with a contact layer 6 composition of Ag-Pd-In exhibited even for very low concentrations of Pd and In (0.5 at.% Pd and 1 at.% In) no detectable corrosion after exposure to salt mist and a faint yellowish discoloration after exposure to hydrogen sulfide, which did not, however, affect the electrical properties of the electrically conducting contact element 2 negatively. The same results were achieved also for a contact layer 6 composition of Ag-Pd-Sn down to very low concentrations of Pd and Sn (0.5 at.% Pd, 1 at.% Sn).

For a contact layer 6 composition comprising Ag, Pd, In and Sn, corrosion resistance effects from In+Sn and Pd could counteract each other. Pd may adversely affect tarnishing resistance compared to if only In+Sn is used. A contact layer 6 composition of Ag-Pd-In-Sn having a Pd content of 0.01 at.% and In/Sn levels within the intervals specified above, resulted in an improved resistance against tarnishing compared to contact layers 6 of pure Ag, but no significantly improved corrosion resistance against salt mist. With an increased Pd level in the Ag-Pd-In-Sn composition of 0.5 at.%, there were no signs of corrosion after salt mist or hydrogen sulfide exposure. Such a contact layer 6 exhibited therefore considerably better corrosion resistance against salt mist and hydrogen sulfide than pure Ag and an improved corrosion resistance against salt mist compared to Ag-In-Sn. Within the range of 0.01 at.% and 5 at.% of Pd an Ag-Pd-In-Sn composition resulted in better corrosion resistance against hydrogen sulfide and salt mist than pure Ag. A Pd content in the range of 0.1 at.% to 5 at.% resulted in improved corrosion resistance against hydrogen sulfide and salt mist compared to contact layer 6 compositions of pure Ag, and to salt mist corrosion compared to Ag-In-Sn compositions. By varying the content of Sn and In the Ag-Pd-In-Sn composition it was found that an Sn level within the range of 0.01 to 10 at.%, and an In level within the range of 0.01 to 5 at.% resulted in improved corrosion resistance compared to pure Ag.

Within the intervals stated above similar results were obtained in the environmental tests for Ag-In-Sn alloys with other noble metals than Pd, or in combination with Pd. For contact layer 6 compositions comprising Ag-Ru-Pd-In-Sn (97.5-0.25-0.25-1-1 at.%), Ag-Pt-In-Sn (97.5-0.5-1-1 at.%) and Ag-Au-In-Sn (97.5-0.5-1-1) there were no signs of corrosion in either of the environmental tests. All three contact layer 6 compositions exhibited considerably higher resistance against corrosion than contact layers 6 of Ag-In-Sn or pure Ag. These results indicate that addition of any noble metal, including Au, Ag, Pd, Pt, Rh, Ir, Ru, Os, Re, or combinations of noble metals, in an Ag-In-Sn composition, would increase the corrosion resistance of the contact layer 6 compared to if pure Ag or Ag-In-Sn compositions are used.

Contact layer 6 compositions comprising Ag-Pd-In, as discussed above, resulted in improved corrosion resistance compared to pure Ag. The positive indication above for the use of any noble metal, including Au, Ag, Pd, Pt, Rh, Ir, Ru, Os, Re, or combinations of noble metals, in an Ag-In-Sn composition should therefore be applicable also for Ag-In compositions. The same reasoning applies for contact layer compositions of Ag-Sn.

It is considered likely that a contact layer 6 composition comprising another base material than Ag, e.g. Sn, Ni, Co, or combinations of base materials, also would result in an electrically conducting contact element 2 with improved corrosion resistance compared to an electrically conducting contact element 2 having a contact layer 6 of only the base material as such. By forming an alloy of two or more metals, it is possible to drastically improve the corrosion resistance of the base material with a sustained or improved contact resistance. It is for example known in the art that an alloy of Cu and Ni has found extensive use in marine applications due to increased corrosion resistance as compared to Cu and Ni alone.

Fig. 1b shows a schematic partial cross section view of an electrically conducting contact element 2 comprising a substrate 4a, 4b and coated thereon a contact layer 6. These parts of the shown structure corresponds to the structure of Fig. 1a and the respective part may be the same or similar as was discussed above in relation to Fig. 1a. Additionally, Fig. 1b comprises an outer protective layer 8 deposited on the contact layer 6. The outer protective layer 8 may be resulting from a PVD or CVD of either a polymeric coating consisting of mainly Si, O, and C or a metal oxide consisting of mainly indium oxide and tin oxide, see e.g. M. Grischke, A. Hieke, F. Morgenweck, H. Dimigen, Diamonds and Related Materials, 1998, 7, 454-458*.* The polymeric coating thickness may be less than 20 nm. The metal oxide layer coating thickness may be less than 100 nm.

By the deposition of the polymeric layer, the protective layer 8 may be formed so that it comprises an outer (top) portion comprising Si, O, C, F resulting from the deposition and/or there may be a reaction during the deposition with the underlying contact layer 6 forming at least part of the protective layer 8.

Conventionally, contact layers, e.g. Au layers, are deposited using plating. The material according to the present disclosure may be plated as well, but is advantageously deposited using evaporation techniques, in particular physical vapor deposition (PVD). Advantages form this include possibility to coat materials that are difficult to plate, e.g. stainless steel and aluminum, it allows for better controllability of layer composition and thickness, and deposition can be made more environmentally friendly. In case of a protective coating 8 resulting from the deposition of the polymeric layer, it is advantageous to use a PVD coating equipment having separate chambers, where a contact element 4 having a contact layer 6 coated in one chamber is moved to a subsequent chamber for coating of the protective layer 8. The present applicant's PVD equipment REELCOATER® and INLINECOATER® may advantageously be used and are adaptable to volume production which previously has been a drawback for evaporation techniques compared to plating.

In addition to coating techniques as mentioned above, the contact layer can be formed separately and then attached, e.g. by soldering, to the contact element. Other conventional techniques that could be used e.g. rolling down a piece of the material, e.g. a wire made of the material, into the surface of the substrate 4 or into an already existing contact layer of a starting material that in a previous step has been provided on top of the substrate.

Fig. 2 is a block diagram schematically showing steps in a method for manufacturing the electrically conducting contact element 2. In step 102 a substrate is provided, which may be one of the substrates discussed in the foregoing. Step 102 may include a coating, e.g. by PVD, of the substrate, such as layer 4b as discussed in the foregoing on a pre-produced substrate 4a, but may also include providing a fully pre-produced substrate, which e.g. may be a contact element made from a base metal or metal alloy. Following this, in step 104, the substrate 4a, 4b is coated with contact layer 6, wherein the contact layer comprises the material as discussed in the foregoing. As already mentioned, step 104 is preferably performed by means of evaporation, preferably by physical vapor deposition (PVD) and preferably from a target material comprising the material. However, also multiple targets, such as one for each constituent of the material, may be used. How target material comprising the material can be provided is discussed in some further detail below. In a last optional step 106, the contact layer 6 is coated, also preferably by means of PVD, with the Si-O-C layer, so that the result is an outer protective layer 8 typically having a thickness below about 20 nm. Such protective layer was discussed above.

The material of the present disclosure can be pre-produced in different ways for further use as a coating material for deposition of a contact layer using PVD, that is, can be provided in the form of, and used as, a target material. In one embodiment the constituent materials are alloyed, that is, melted and mixed in a liquid state and then cooled down. In another embodiment one or more of the constituents are being provided in the form of powders which are sintered, including cold or hot isostatic pressing of the powders (CIPing or HIPing). The pressed powders are then heat treated at about 200-400°C for 1-4 hours. In yet another embodiment, a target material comprising the material is made from a starting material being a pure metal, or an alloy of parts of the material, for example using the base material as starting material, then the remaining constituents are being provided by means of diffusion in an oven, vacuum chamber or chemical bath where the starting material is located.

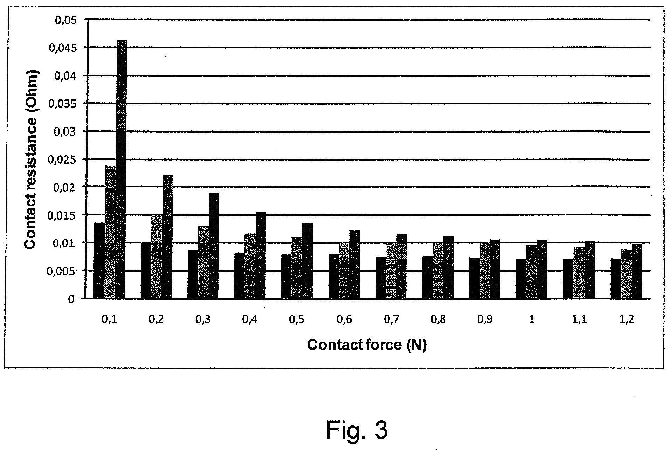

Fig. 3 shows experimental results from evaluation of one embodiment of an electrically conducting contact element 2 before and after environmental test. In each group, the left column indicates result as deposited, the middle column indicates results after salt spray exposure (IEC 60068-2-11 Test Ka) and the right column indicates results after mixed gas exposure (IEC 60068-2-60 Test Ke). The evaluated electrically conducting contact element is in accordance with Fig. 1a, where the substrate 4a is a Grade 304 stainless steel which has been PVD coated with a 0.3 µm Ni-alloy, containing at least 72 at.% Ni, forming substrate layer 4b, upon which a 0.3 µm contact layer 6 has been coated using PVD. The contact layer is formed from an Ag-alloy comprising 95.5 at.% Ag, 1 at.% In, 1 at.% Sn, and 2.5 at.% Pd. The salt spray exposure involves subjecting the electrical conducing contact element 2 to a salt mist during 48 hours, at 35°C and 90-95 % relative humidity (RH). The mixed gas exposure involves subjecting the electrical conducting contact element to the mixed gas (H₂S 0,1 ppm + SO₂ 0,5 ppm at 25°C, 75 % RH.) for 2 to 96 hours.

The material in the present disclosure, which may be seen as a compound material, is meant to i.a. include mixture of the constituting elements, that is, a metal based material or metallic mixture, for example but not necessary as in an alloy, and not requiring a fully homogenous distribution of the mixed constituents. For example, when the material is provided in the form of the contact layer 6 discussed in the foregoing, some of the constituting elements, for example Sn and In, may be in higher concentration in a surface portion of the layer. It is also possible with other variations of composition throughout a contact layer made from the material, e.g. other variations in concentration, such as gradients, and the layer may include a multilayered structure, e.g. including atomic thin layers of some constituent material laminated with layers of another constituent material.

The abbreviations used for the chemical elements in this disclosure are all well know, each unambiguously corresponding to a chemical element: Ag (silver), Au (gold), Ni (nickel), Sn (tin), In (indium), Pd (palladium), Cu (copper), Si (silicon), C (carbon), O (oxygen), F (flourine), Na (sodium), CI (chlorine), Br (bromine), I (iodine), S (sulfur), H (hydrogen), Cobalt (Co).

Any illustration and description in the drawings and in the foregoing text is to be considered exemplary and not restrictive. The invention is not limited to the disclosed embodiments.

The present invention is defined by the claims and variations to the disclosed embodiments can be understood and effected by the person skilled in the art in practicing the claimed invention, for example by studying the drawings, the disclosure, and the claims. Use of the word "comprising" in the claims does not exclude other elements or steps, and use of the article "a" or "an" does not exclude a plurality. Occurrence of features in different dependent claims does not per se exclude a combination of these features. Any reference signs in the claims are for increasing intelligibility and shall not be construed as limiting the scope of the claims.

## Claims

1. A material for providing an electrically conducting contact layer, the material comprising a base material being any one of Ag, Ni, Co, a first metal salt of any one thereof, or an alloy of any one or more thereof, wherein the material further comprises In within a range of 0.01 at.% to 10 at.% and Sn within a range of 0.01 at.% to 10 at.% and at least one element other than the base material selected from the group including Au, Ag, Pd, Pt, Rh, Ir, Ru, Os, Re, or any combination thereof, within a range of 0.01 at.% to 10 at.%.

2. The material as claimed in claim 1, wherein the material comprises less than 5 at.% In, less than 10 at.% Sn, and less than or about 5 at.% of said at least one element or combinations of elements.

3. The material as claimed in claims 1 or 2, wherein the material comprises the base material within a range of 70 at.% to 99.7 at.%, such that the sum of all constituents in the material is 100 at.%.

4. The material as claimed in any of the preceding claims 1-3, wherein the base material is Ag.

5. An electrically conducting contact element (2) comprising a substrate (4) and coated thereon a contact layer (6) comprising the material as claimed in any one of the preceding claims 1-4.

6. The electrically conducting contact element as claimed in claim 5, wherein said substrate is non-conductive.

7. The electrically conducting contact element (2) as claimed in claim 5 or 6, further comprising an outer protective layer (8) deposited on the contact layer (6), said outer protective layer (8) comprising, preferably substantially consisting of, Si, O, and C, or indium oxide and tin oxide.

8. A method for providing an electrically conducting contact element (2), comprising the steps of:
providing (102) a substrate (4); and
providing (104) the substrate with a contact layer (6), wherein the contact layer comprises the material as claimed in any one of claims 1-4.

9. The method as claimed in claim 8, wherein the method further comprises the step of:
coating (106) the surface of the contact layer (6) with an outer protective layer (8) resulting from PVD or CVD of either a polymeric coating substantially consisting of Si, O, and C, or a metal oxide substantially consisting of indium oxide and tin oxide.

10. Use of an electrically conducting contact element as claimed any one of claims 5 to 7 in signal applications.

## Patentansprüche

1. Material zum Bereitstellen einer elektrisch leitenden Kontaktschicht, wobei das Material ein Basismaterial, das irgendeines von Ag, Ni, Co ist, ein erstes Metallsalz von irgendeinem dieser oder eine Legierung von irgendeinem oder mehreren dieser umfasst, wobei das Material ferner In innerhalb eines Bereichs von 0,01 At.-% bis 10 At.-% und Sn innerhalb eines Bereichs von 0,01 At.-% bis 10 At.-% und mindestens ein Element, das ein anderes als das Basismaterial ist, ausgewählt aus der Gruppe, die Au, Ag, Pd, Pt, Rh, Ir, Ru, Os, Re beinhaltet, oder irgendeine Kombination dieser innerhalb eines Bereichs von 0,01 At.-% bis 10 At.-% umfasst.

2. Material nach Anspruch 1, wobei das Material weniger als oder 5 At.-% In, weniger als oder 10 At.-% Sn und weniger als oder 5 At.-% des mindestens einen Elementes oder von Kombinationen von Elementen umfasst.

3. Material nach Anspruch 1 oder 2, wobei das Material das Basismaterial innerhalb eines Bereichs von 70 At.-% bis 99,7 At.-% umfasst, sodass die Summe aller Bestandteile in dem Material 100 At.-% beträgt.

4. Material nach einem der vorhergehenden Ansprüche 1 bis 3, wobei das Basismaterial Ag ist.

5. Elektrisch leitendes Kontaktelement (2), umfassend ein Substrat (4) und darauf aufgetragen eine Kontaktschicht (6), umfassend das Material nach einem der vorhergehenden Ansprüche 1 bis 4.

6. Elektrisch leitendes Kontaktelement nach Anspruch 5, wobei das Substrat nicht leitfähig ist.

7. Elektrisch leitendes Kontaktelement (2) nach Anspruch 5 oder 6, ferner umfassend eine äußere Schutzschicht (8), die auf der Kontaktschicht (6) abgeschieden ist, wobei die äußere Schutzschicht (8) bevorzugt im Wesentlichen aus Si, O und C besteht oder Indiumoxid und Zinnoxid umfasst.

8. Verfahren zum Bereitstellen eines elektrisch leitenden Kontaktelementes (2), umfassend die Schritte:
Bereitstellen (102) eines Substrats (4); und
Bereitstellen (104) des Substrats mit einer Kontaktschicht (6), wobei die Kontaktschicht das Material nach einem von Anspruch 1 bis 4 umfasst.

9. Verfahren nach Anspruch 8, wobei das Verfahren ferner den Schritt umfasst:
Beschichten (106) der Oberfläche der Kontaktschicht (6) mit einer äußeren Schutzschicht (8), die aus PVD oder CVD von entweder einer polymeren Beschichtung, die im Wesentlichen aus Si, O und C besteht, oder einem Metalloxid, das im Wesentlichen aus Indiumoxid und Zinnoxid besteht, resultiert.

10. Benutzung eines elektrisch leitenden Kontaktelementes nach einem von Anspruch 5 bis 7 in Signalanwendungen.

## Revendications

1. Matériau pour fournir une couche de contact électriquement conductrice, le matériau comprenant un matériau de base qui est un de Ag, Ni, Co, un premier sel métallique de l'un quelconque de ceux-ci ou un alliage de l'un quelconque ou de plusieurs de ceux-ci, où le matériau comprend en outre In dans une plage de 0,01 % at. à 10 % at. et Sn dans une plage de 0,01 % at. à 10 % at. et au moins un élément différent du matériau de base choisi dans le groupe comprenant Au, Ag, Pd, Pt, Rh, Ir, Ru, O, Re ou une quelconque de leurs combinaisons, dans une plage de 0,01 % at. à 10 % at.

2. Matériau selon la revendication 1, dans lequel le matériau comprend moins de 5 % at. de In, moins de 10 % at. de Sn et moins de ou environ 5 % at. dudit au moins un élément ou combinaison d'éléments.

3. Matériau selon les revendications 1 ou 2, dans lequel le matériau comprend le matériau de base dans une plage de 70 % at. à 99,7 % at., de telle manière que la somme de tous les constituants dans le matériau est de 100 % at.

4. Matériau selon l'une quelconque des revendications précédentes 1 à 3, dans lequel le matériau de base est Ag.

5. Elément de contact électriquement conducteur (2) comprenant un substrat (4) et revêtue dessus une couche de contact (6) comprenant le matériau selon l'une quelconque des revendications précédentes 1 à 4.

6. Elément de contact électriquement conducteur selon la revendication 5, dans lequel ledit substrat est non conducteur.

7. Elément de contact électriquement conducteur (2) selon la revendication 5 ou 6, comprenant en outre une couche protectrice externe (8) déposée sur la couche de contact (6), ladite couche protectrice externe (8) comprenant, de préférence essentiellement constituée de Si, O et C ou d'oxyde d'indium et d'oxyde d'étain.

8. Procédé pour fournir un élément de contact électriquement conducteur (2), comprenant les étapes de :
fourniture (102) d'un substrat (4) ; et
fourniture (104) du substrat avec une couche de contact (6), où la couche de contact comprend le matériau selon l'une quelconque des revendications 1 à 4.

9. Procédé selon la revendication 8, dans lequel le procédé comprend en outre les étapes de :
revêtement (106) de la surface de la couche de contact (6) avec une couche protectrice externe (8) résultant de PVD ou de CVD d'un revêtement polymère constitué essentiellement de Si, O et C ou d'un oxyde métallique constitué essentiellement d'oxyde d'indium et d'oxyde d'étain.

10. Utilisation d'un élément de contact électriquement conducteur selon l'une quelconque des revendications 5 à 7 dans des applications de signal.
